(19) Europäisches Patentamt
European Patent Office
Office européen des brevets

(11) **EP 2 850 440 B1**

(12) **FASCICULE DE BREVET EUROPEEN**

(45) Date de publication et mention de la délivrance du brevet:
**29.06.2016 Bulletin 2016/26**

(51) Int Cl.:
***G01R 19/25*** *(2006.01)*

(21) Numéro de dépôt: **13727279.5**

(22) Date de dépôt: **13.05.2013**

(86) Numéro de dépôt international:
**PCT/FR2013/051041**

(87) Numéro de publication internationale:
**WO 2013/171415 (21.11.2013 Gazette 2013/47)**

(54) **PROCEDE DE DETERMINATION PAR ECHANTILLONNAGE D'UNE VALEUR MAXIMALE DE TENSION D'UN SIGNAL DE CHARGE**

VERFAHREN ZUM ERMITTELN EINES MAXIMALEN SPANNUNGSWERTES EINES LASTSIGNALS DURCH ABTASTUNG

METHOD FOR DETERMINING A MAXIMUM VOLTAGE VALUE OF A LOAD SIGNAL BY SAMPLING

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **15.05.2012 FR 1254409**

(43) Date de publication de la demande:
**25.03.2015 Bulletin 2015/13**

(73) Titulaire: **Renault S.A.S.**
**92100 Boulogne-Billancourt (FR)**

(72) Inventeurs:
• **COURTEMANCHE, Florian**
**F-78000 Versailles (FR)**
• **LE-VOURCH, Yves**
**F-78150 Le Chesnay (FR)**
• **PEUCHANT, Thomas**
**F-75014 Paris (FR)**

(56) Documents cités:
**WO-A2-2011/058259     US-A- 5 631 553**

## Description

L'invention a pour domaine technique les systèmes de mesures à haute fréquence, et plus particulièrement les systèmes de mesures à haute fréquence à sous échantillonnage.

Dans les systèmes de mesures à hautes fréquences communiquant en série, les temps de mesure et de traitement des données doivent être optimisés afin de pouvoir effectuer toutes les mesures avec une précision acceptable. Pour cela, on cherche à minimiser le temps alloué à chaque mesure.

Dans le domaine des batteries pour véhicules automobiles, ce problème se pose lors de la détection du maximum d'une tension d'une cellule pendant la charge par un chargeur monophasé d'une batterie à cellules.

Lors d'une telle charge, la tension d'une cellule présente une composante quasiment continue variant lentement et une composante alternative dont l'allure est directement liée au courant de charge délivré par le chargeur. Lors d'une charge monophasée, cette composante alternative est un signal sinusoïdal redressé. Cette partie du signal est nommée oscillation (en langue anglaise, « ripple »). La détection du maximum du signal demande un échantillonnage suffisant précis des mesures.

La tension de cellule est un paramètre particulièrement important à surveiller. En effet, lorsque cette tension sort de la plage de valeurs préconisées, des réactions électrochimiques anormales se produisent, conduisant à une dégradation de la batterie. Ces évènements peuvent ne pas se produire immédiatement, mais leur processus s'amorce dès que la tension de la cellule est en dehors de la plage de tension autorisée. Il est donc nécessaire d'agir immédiatement lorsqu'une borne supérieure ou inférieure est atteinte. Dans un tel cas, la réaction peut être de limiter ou de stopper le courant pour rester dans la plage de tension autorisée. On doit donc être capable de mesurer les tensions maximales de chaque cellule de la batterie.

Par sécurité, une valeur de marge est ajoutée à la valeur mesurée. La valeur mesurée prise en compte est donc surestimée. Comme on l'a vu au-dessus, une tension de cellule élevée provoque une puissance de charge faible. Une surestimation de la tension de cellule étant transparente pour la détermination de la puissance de charge, elle aura pour conséquence une baisse de la puissance de charge, ce qui impliquera une augmentation du temps de charge.

Il s'agit alors de minimiser la valeur de la marge permettant d'assurer le maintien du signal entre des bornes permettant de maximiser la puissance de charge, tout en maintenant la sécurité de chaque cellule.

Il est également nécessaire d'optimiser le temps alloué à la mesure de tension.

Deux solutions existent actuellement pour répondre aux contraintes d'un temps de mesure faible et d'une précision importante de la mesure.

Une première solution est de paralléliser les moyens de mesure de sorte à réduire les communications en série. Toutefois, cela implique une multiplication d'éléments matériels qui génère une augmentation de coût non négligeable.

Une autre solution consiste à se satisfaire d'un échantillonnage faible des mesures, la valeur moyenne du signal étant alors la seule valeur significative accessible. Cela peut être réalisé en augmentant la marge de sécurité autour des bornes supérieure ou inférieure. En vertu du calcul de puissance de charge expliqué plus haut, l'augmentation de la marge de sécurité mènerait à une sous-estimation permanente de la puissance de charge. Le temps de charge est alors directement augmenté.

Le document WO 2011/058259 décrit une machine tournante à excitation munie d'un dispositif régulateur de type numérique.

Il demeure ainsi un problème de détermination des paramètres de mesures permettant de minimiser la marge de sécurité et d'augmenter la puissance de charge tout en assurant la sécurité des cellules de batterie automobile.

L'invention a pour objet un procédé de détermination par échantillonnage à une fréquence d'une valeur maximale de tension d'un signal de charge d'au moins une cellule de batterie d'un véhicule automobile, le signal de charge à échantillonner étant sinusoïdal redressé et ayant une fréquence supérieure à la fréquence d'échantillonnage. Le procédé comprend les étapes suivantes :

> on détermine la fréquence d'échantillonnage, la durée de mesure à la fréquence d'échantillonnage et l'imprécision associée,
> on mesure la tension de charge avec la fréquence d'échantillonnage déterminée et avec la durée de mesure déterminée, et
> on détermine le maximum de la tension de charge.

On peut déterminer la fréquence d'échantillonnage, la durée de mesure et l'imprécision associée en réalisant les étapes suivantes :

> a) Pour chaque fréquence d'échantillonnage d'une gamme de fréquences d'échantillonnage, on réalise les étapes b) à e) suivantes,

b) Pour chaque valeur du déphasage d'une gamme de déphasages, on réalise les étapes c) à d) suivantes,

c) Pour chaque durée de mesure d'une gamme de durées de mesure, on détermine l'imprécision associée à une mesure à la fréquence présentant un déphasage en fonction de la valeur de durée de mesure,

d) On choisit l'imprécision la plus faible pour chaque déphasage parmi toutes les imprécisions relatives au déphasage considéré, pour la fréquence d'échantillonnage considérée,

e) On choisit l'imprécision « au pire cas » pour chaque fréquence d'échantillonnage parmi les valeurs d'imprécision les plus faibles déterminées pour chaque déphasage et pour chaque fréquence d'échantillonnage considérée,

f) On détermine l'imprécision la plus faible parmi les valeurs d'imprécision les plus faibles déterminées pour chaque fréquence d'échantillonnage,

g) On détermine la fréquence d'échantillonnage et la durée de mesure correspondant à l'imprécision la plus faible.

On peut définir une gamme de fréquences d'échantillonnage comprenant une fréquence minimale, une fréquence maximale, et un pas de fréquence,
on peut définir une gamme de déphasages comprenant un déphasage minimum, un déphasage maximum et un pas de déphasage, et
on peut définir une gamme de durées de mesure, comprenant une durée minimale de mesure, une durée maximale de mesure et un pas de durée de mesure.

On peut définir la durée maximale de mesure comme étant issue du produit de l'inverse de la fréquence d'échantillonnage par la partie entière du rapport de la fréquence du signal à échantillonner par la fréquence d'échantillonnage.

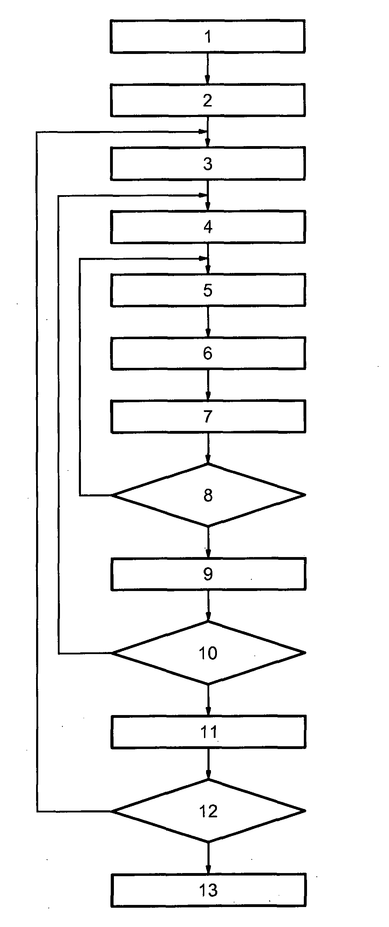

D'autres buts, caractéristiques et avantages apparaîtront à la lecture de la description suivante donnée uniquement en tant qu'exemple non limitatif et faite en référence à la figure unique annexée sur laquelle est illustré un procédé de détermination d'une valeur maximale de tension.

La tension alternative employée pour charger une batterie est généralement de forme sinusoïdale. Afin de déterminer la marge minimum à appliquer, on doit disposer d'une mesure précise du maximum de la tension alternative de charge.

Le signal de mesure de cette tension alternative peut être défini par l'équation suivante :

$$s(t) = A \cdot \left| \sin(\omega \cdot t + \Phi) \right| + B \qquad (Eq. \ 1)$$

dans laquelle :

A : amplitude du signal de mesure
B : valeur moyenne du signal
$\omega$ : pulsation du signal $\omega = 2.\pi.f$
f : fréquence en Hz
$\Phi$ : déphasage du signal variant de 0 à $\pi$
t : variable temporelle dont l'origine est prise à l'instant d'acquisition du premier échantillon.

Le signal temporel s(t) est échantillonné à la pulsation $\omega_e$. Les points de mesure résultant de cet échantillonnage satisfont l'équation suivante :

$$s_e(k) = A \cdot \left| \sin(2 \cdot \pi \cdot \frac{\omega}{\omega_e} \cdot k + \Phi) \right| \qquad (Eq. \ 2)$$

où k est un entier variant de 0 à n.

Après n mesures à la pulsation $\omega_e$, on obtient un vecteur comprenant les n+1 échantillonnages $S_e(0)$ à $S_e(n)$ formant le vecteur $S_\Phi^*$ suivant :

$$S_\Phi^* = [s_e^\Phi(0) \quad s_e^\Phi(1) \quad ... \quad s_e^\Phi(k) \quad ... \quad s_e^\Phi(n)] \qquad (Eq. \ 3)$$

Lors d'une mesure, seul le vecteur $S_\Phi^*$ est accessible. On ne dispose par conséquent que d'une estimation de A par l'intermédiaire du maximum de $\overline{S_\Phi^*}$. En d'autres termes, on ne peut déterminer que le maximum parmi les valeurs disponibles dans le vecteur $S_\Phi^*$. Il n'est donc pas possible de déterminer si le signal est passé en réalité par des valeurs supérieures qui n'ont pas été mesurées. Cependant, cette situation peut être minimisée en augmentant le nombre de points acquis. Il apparaît alors qu'il faut déterminer le compromis entre le nombre de points acquis et le temps de mesure disponible.

En résumé, pour avoir une bonne précision de l'estimation de A, il faut obtenir un nombre d'échantillons n suffisant, et ce pour une pulsation $\omega_e$ donnée.

Le déphasage $\Phi$ dépend de l'instant auquel le premier échantillon $s_e^\Phi(0)$ est mesuré. C'est un paramètre contraignant du problème puisqu'il est impossible de le connaître ne sachant pas à quel moment est mesuré le premier échantillon. On s'affranchit de ce problème par un calcul du maximum de $S_\Phi^*$, dit « au pire cas ». Cela revient à chercher la moins bonne estimation du maximum en fonction de $\Phi$. Dans ces conditions, une mesure fonction du déphasage ne peut être qu'égale ou meilleure à cette estimation « au pire cas ». On peut ainsi faire disparaître la contribution du déphasage, que l'on ne peut pas contrôler lors d'une mesure.

D'une manière générale, un échantillon $s_e(k)$ présente une forme issue de la superposition d'une composante continue et d'une composante sinusoïdale. Pour maximiser $s_e(k)$, on cherche à maximiser sa partie sinusoïdale.

La fonction sinusoïdale $\varphi \rightarrow |\sin(\varphi)|$ est maximale pour $\varphi = \dfrac{\pi}{2} + p \cdot \pi$ avec p entier. La variable p est un entier variant entre 0 et p_max. La valeur p_max est obtenue en choisissant l'entier le plus proche du rapport de la fréquence à échantillonner par la fréquence d'échantillonnage. En pratique, on privilégiera une valeur de p variant entre 2 et p_max. En effet, une valeur de p égale à 1 ne permet pas d'obtenir une mesure fiable. La valeur p peut être assimilée à une durée de mesure débutant à chaque alternance de la fréquence d'échantillonnage et dépendant du signal à échantillonner. On comprend ainsi que la valeur de p ne peut correspondre au maximum qu'à la durée entre deux échantillonnages, un nombre de mesures du signal à échantillonner étant réalisé dans cette durée.

Pour maximiser $s_e(k)$, on cherche donc à résoudre l'équation suivante :

$$2\pi \cdot \frac{\omega}{\omega_e} \cdot n + \Phi = \frac{\pi}{2} + p \cdot \pi \qquad\qquad (Eq. \ 4)$$

La résolution de l'équation 4 donne la valeur suivante de n.

$$n = \frac{\omega_e}{\omega} \cdot \left[ \left( \frac{1}{4} - \frac{\varphi}{2\pi} \right) + \frac{p}{2} \right] \qquad\qquad (Eq. \ 5)$$

Pour un vecteur $S_\Phi^*$ de taille n tel que n vérifie l'équation 5, on aura :

$$\max(S_\Phi^*) = A \qquad\qquad (Eq. \ 6)$$

La difficulté de résolution de cette équation réside dans le fait que p et n sont des entiers. De manière générale, cette équation n'admet donc pas de solution.

Toutefois, quel que soit p entier, il existe un réel x vérifiant l'équation 5. On définit la suite X de points $x_p$ tels que :

$$x_p = \frac{\omega_e}{\omega} \cdot \left[ \left( \frac{1}{4} - \frac{\varphi}{2\pi} \right) + \frac{p}{2} \right] \qquad\qquad (Eq. \ 7)$$

Par ailleurs, cette équation doit être résolue sur un intervalle de temps de 0,1 seconde. Or,

$$\varphi = \frac{\pi}{2} + p \cdot \pi = \omega \cdot t + \Phi \qquad \text{(Eq. 8)}$$

d'où

$$p \le \frac{1}{\pi} \cdot \left( 0.1 \cdot \omega - \frac{\pi}{2} \right) \qquad \text{(Eq. 9)}$$

Une fois la suite X des points $x_p$ évaluée, on choisit le point $x_p$ le plus proche d'un entier. On définit ainsi le nombre n d'échantillons à mesurer. Pour cela, on résout l'équation suivante :

$$n = \min \left| \text{round}(x_p) - x_p \right| \qquad \text{(Eq. 10)}$$

où round() est la fonction qui donne l'entier le plus proche d'un réel. En d'autres termes, pour chaque valeur de p, on définit un point $x_p$ entouré par deux entiers n et n+1. Dans nos échantillons, on aura les valeurs du signal en n et n+1 : $s_e^{\Phi}(n)$ et $s_e^{\Phi}(n+1)$. Le point xp qui sera le plus proche d'un entier n donnera la meilleure précision. On trouve ce point grâce à l'équation 10.

On peut écrire n sous la forme n* = $x_p$ + ε, ε étant assimilable à une erreur d'estimation de n par l'entier $x_p$. On est alors capable d'estimer l'erreur faite sur le maximum de s(t) :

$$s_e^{\Phi}(n^*) = A \cdot \left| \sin\left( 2 \cdot \pi \cdot \frac{\omega}{\omega_e} \cdot \left( x_p + \varepsilon \right) + \Phi \right) \right| \qquad \text{(Eq. 11)}$$

Ce qui peut être développé de la façon suivante :

$$s_e^{\Phi}(n^*) = A \cdot \left| \sin\left( 2 \cdot \pi \cdot \frac{\omega}{\omega_e} \cdot x_p + \Phi + 2 \cdot \pi \cdot \frac{\omega}{\omega_e} \cdot \varepsilon \right) \right| \qquad \text{(Eq. 12)}$$

ou, par définition,

$$2 \cdot \pi \cdot \frac{\omega}{\omega_e} \cdot x_p + \Phi = \frac{\pi}{2} + p\pi \qquad \text{(Eq. 13)}$$

et,

$$\sin\left( \frac{\pi}{2} + p\pi + x \right) = \cos(x) \qquad \text{(Eq. 14)}$$

On obtient donc

$$s_e^{\Phi}(n^*) = A \cdot \left| \cos\left( 2 \cdot \pi \cdot \frac{\omega}{\omega_e} \cdot \varepsilon \right) \right| \qquad \text{(Eq. 15)}$$

On obtient ainsi $s_e^{\Phi}(n^*)$ dont la partie en cosinus correspond à l'imprécision sur le maximum A de s(t).

Pour rappel, il s'agit ici de trouver une fréquence d'échantillonnage $\omega_e/2\pi$, notée fe, adaptée à une mesure de l'amplitude A du signal de mesure s(t), de forme sinusoïdale. Il s'agit également de disposer de l'incertitude sur A en évaluant $s_e^\Phi(n)$ pour chaque valeur de $\Phi$ en appliquant l'équation 15.

Le procédé débute, à l'étape 1, par la détermination d'une gamme de fréquences d'échantillonnage comprenant une fréquence minimale, une fréquence maximale, et un pas de fréquence. La fréquence d'échantillonnage fe varie entre 0 et la fréquence maximale $fe_{max}$ du système d'échantillonnage. Le pas de fréquence d'échantillonnage peut être une fraction de la fréquence maximale de sorte que la fréquence maximale corresponde à un nombre entier de pas de fréquence.

De même, on définit également une gamme de déphasages comprenant un déphasage minimum, un déphasage maximum et un pas de déphasage.

Le déphasage varie de 0 à $\pi$. Le pas est défini de préférence de sorte que le déphasage maximum corresponde à un nombre entier de pas de déphasage.

Enfin, on définit une gamme de valeur de p, variant entre 2 et $p_{max}$. La valeur de p correspond également à la durée de mesure à chaque échantillonnage. Le pas est généralement défini égal à l'unité.

Au cours d'une étape 2, on choisit la fréquence minimale de la gamme de fréquences d'échantillonnage.

Au cours d'une étape 3, on choisit le déphasage minimum parmi la gamme de déphasages.

Au cours d'une étape 4, on choisit la première valeur de p parmi la gamme de valeurs de p.

Au cours d'une étape 5, on estime la valeur de xp par application de l'équation 7.

Au cours d'une étape 6, on détermine le nombre n d'échantillons par application de l'équation 10. En connaissant la fréquence d'échantillonnage fe, la durée de mesure est égale à n/fe.

Au cours d'une étape 7, on détermine l'imprécision $s_e^\Phi(n^*)$ associée à une mesure à la fréquence $\omega_e$ et au déphasage $\Phi$ en fonction de la valeur du paramètre p par application de l'équation 15.

Au cours d'une étape 8, on détermine si la valeur p choisie à l'étape 4 est la dernière valeur de la gamme de p.

Si tel n'est pas le cas, on exécute de nouveau les étapes 5 à 7 en incrémentant la valeur de p par le pas de valeur de p.

On obtient ainsi des valeurs de l'imprécision $s_e^\Phi(n^*)$ associée chacune à une valeur différente du paramètre p. Pour chaque imprécision, la fréquence $\omega_e$ et le déphasage $\Phi$ sont fixés.

Lorsque la valeur p considérée est la dernière, le procédé se poursuit à l'étape 9, au cours de laquelle on détermine parmi les valeurs d'imprécision obtenues la valeur la plus faible. On mémorise ensuite dans une cartographie la valeur d'imprécision la plus faible, ainsi que les valeurs associées de fréquence fe, de déphasage $\Phi$ et de paramètre p.

Le procédé se poursuit à l'étape 10 au cours de laquelle on détermine si la valeur de déphasage choisie à la troisième étape est la dernière valeur de la gamme de déphasages.

Si tel n'est pas le cas, on exécute de nouveau les étapes 4 à 8 en incrémentant le déphasage par le pas de déphasage.

On obtient ainsi un ensemble de valeurs minimales de l'imprécision $s_e^\Phi(n^*)$ associée chacune à une valeur de déphasage $\Phi$. Pour chaque imprécision, la fréquence fe est fixée. Chaque valeur minimale de l'imprécision étant issue de la première boucle, elle est associée à une valeur p particulière.

Lorsque la valeur de déphasage considérée est la dernière, le procédé se poursuit à l'étape 11, au cours de laquelle on détermine parmi les valeurs d'imprécision obtenues la valeur « au pire cas ». Une telle méthode de choix consiste à choisir la mesure pour laquelle la précision est la moins bonne.

On obtient ainsi la moins bonne valeur de l'imprécision $s_e^\Phi(n^*)$ pour une mesure à une fréquence fe. Chaque moins bonne valeur de l'imprécision est par ailleurs associée à une valeur du paramètre p. La méthode de choix employée a pour effet de gommer l'influence du déphasage. En effet, la précision sera au pire égale à la moins bonne valeur et dans le meilleur des cas elle sera bien plus précise. Le déphasage étant difficilement contrôlable, cette méthode de choix permet de disposer d'une valeur surestimée mais toujours valable de l'imprécision de mesure.

Le procédé se poursuit à l'étape 12 au cours de laquelle on détermine si la fréquence choisie à la troisième étape est la dernière valeur de la gamme de fréquences.

Si tel n'est pas le cas, on exécute de nouveau les étapes 4 à 11 en incrémentant la fréquence par le pas de fréquence.

Lorsque la valeur de fréquence considérée est la dernière, le procédé se poursuit à l'étape 13.

On obtient alors un ensemble des pires valeurs de l'imprécision $s_e^\Phi(n^*)$ associée chacune à une de la fréquence fe. De par les étapes précédentes, chaque valeur de l'imprécision est associée à une valeur de p particulière.

Le procédé se termine en déterminant parmi les valeurs de l'imprécision, celle qui est la plus faible. On détermine ensuite les valeurs de fréquence d'échantillonnage fe et de nombre de mesure p associées à la valeur choisie. La fréquence d'échantillonnage fe et le nombre de mesures p sont employés afin de configurer les moyens de mesure pour mesurer la tension de charge.

## Revendications

1. Procédé de détermination par échantillonnage à une fréquence d'une valeur maximale de tension d'un signal de charge d'au moins une cellule de batterie d'un véhicule automobile, le signal de charge à échantillonner étant sinusoïdal redressé et ayant une fréquence supérieure à la fréquence d'échantillonnage, **caractérisé par le fait qu'**il comprend les étapes suivantes :

   on détermine la fréquence d'échantillonnage, la durée de mesure à la fréquence d'échantillonnage et l'imprécision associée,
   on mesure la tension de charge avec la fréquence d'échantillonnage déterminée et avec la durée de mesure déterminée, et
   on détermine le maximum de la tension de charge.

2. Procédé selon la revendication 1, dans lequel on détermine la fréquence d'échantillonnage, la durée de mesure et l'imprécision associée en réalisant les étapes suivantes :

   a) Pour chaque fréquence d'échantillonnage d'une gamme de fréquences d'échantillonnage, on réalise les étapes b) à e) suivantes,
   b) Pour chaque valeur du déphasage d'une gamme de déphasages, on réalise les étapes c) à d) suivantes,
   c) Pour chaque durée de mesure d'une gamme de durée de mesures, on détermine l'imprécision associée à une mesure à la fréquence présentant un déphasage en fonction de la valeur de durée de mesure,
   d) On choisit l'imprécision la plus faible pour chaque déphasage parmi toutes les imprécisions relatives au déphasage considéré, pour la fréquence d'échantillonnage considérée,
   e) On choisit l'imprécision « au pire cas » pour chaque fréquence d'échantillonnage parmi les valeurs d'imprécision les plus faibles déterminées pour chaque déphasage et pour chaque fréquence d'échantillonnage considérée,
   f) On détermine l'imprécision la plus faible parmi les valeurs d'imprécision les plus faibles déterminées pour chaque fréquence d'échantillonnage,
   g) On détermine la fréquence d'échantillonnage et la durée de mesure correspondant à l'imprécision la plus faible.

3. Procédé selon l'une quelconque des revendications précédentes, dans lequel on définit une gamme de fréquences d'échantillonnage comprenant une fréquence minimale, une fréquence maximale, et un pas de fréquence,
   on définit une gamme de déphasages comprenant un déphasage minimum, un déphasage maximum et un pas de déphasage, et
   on définit une gamme de durées de mesure, comprenant une durée minimale de mesure, une durée maximale de mesure et un pas de durée de mesure.

4. Procédé selon la revendication 3, dans lequel on définit la durée maximale de mesure comme étant issue du produit de l'inverse de la fréquence d'échantillonnage par la partie entière du rapport de la fréquence du signal à échantillonner par la fréquence d'échantillonnage.

## Patentansprüche

1. Verfahren zur Bestimmung eines maximalen Spannungswerts eines Lastsignals mindestens einer Batteriezelle eines Kraftfahrzeugs durch Abtastung mit einer Frequenz, wobei das abzutastende Lastsignal ein gleichgerichtetes Sinussignal ist und eine höhere Frequenz als die Abtastfrequenz hat, **dadurch gekennzeichnet, dass** es die folgenden Schritte enthält:

   die Abtastfrequenz, die Messdauer bei der Abtastfrequenz und die zugeordnete Ungenauigkeit werden bestimmt,
   die Lastspannung wird mit der bestimmten Abtastfrequenz und mit der bestimmten Messdauer gemessen, und

das Maximum der Lastspannung wird bestimmt.

**2.** Verfahren nach Anspruch 1, wobei die Abtastfrequenz, die Messdauer bei der Abtastfrequenz und die zugeordnete Ungenauigkeit bestimmt werden, indem die folgenden Schritte ausgeführt werden:

a) für jede Abtastfrequenz eines Bereichs von Abtastfrequenzen werden die folgenden Schritte b) bis e) durchgeführt,
b) für jeden Wert der Phasenverschiebung eines Bereichs von Phasenverschiebungen werden die folgenden Schritte c) bis d) durchgeführt,
c) für jede Messdauer eines Bereichs von Messdauern wird die einer Messung bei der Frequenz zugeordnete Ungenauigkeit bestimmt, die eine Phasenverschiebung abhängig vom Messdauerwert hat,
d) für jede Phasenverschiebung wird die geringste Ungenauigkeit unter allen Ungenauigkeiten bezüglich der betreffenden Phasenverschiebung für die betreffende Abtastfrequenz ausgewählt,
e) die Ungenauigkeit «im schlimmsten Fall» wird für jede Abtastfrequenz unter den geringsten Ungenauigkeitswerten ausgewählt, die für jede Phasenverschiebung und für jede betreffende Abtastfrequenz bestimmt sind,
f) die geringste Ungenauigkeit wird unter den für jede Abtastfrequenz bestimmten geringsten Ungenauigkeitswerten ausgewählt,
g) die Abtastfrequenz und die Messdauer werden ausgewählt, die der geringsten Ungenauigkeit entsprechen.

**3.** Verfahren nach einem der vorhergehenden Ansprüche, wobei ein Bereich von Abtastfrequenzen definiert wird, der eine minimale Frequenz, eine maximale Frequenz und einen Frequenzgang enthält,
ein Bereich von Phasenverschiebungen definiert wird, der eine minimale Phasenverschiebung, eine maximale Phasenverschiebung und einen Phasenverschiebungsgang enthält, und
ein Bereich von Messdauern definiert wird, der eine minimale Messdauer, eine maximale Messdauer und einen Messdauergang enthält.

**4.** Verfahren nach Anspruch 3, wobei die maximale Messdauer als vom Produkt aus dem Umkehrwert der Abtastfrequenz und dem ganzzahligen Teil des Verhältnisses der Frequenz des durch die Abtastfrequenz abzutastenden Signals stammend definiert wird.

**Claims**

**1.** Method for determining a maximum voltage value of a charging signal of at least one battery cell of a motor vehicle, by sampling at a frequency, the charging signal to be sampled being rectified sinusoidal and having a frequency greater than the sampling frequency, **characterized in that** it comprises the following steps:

the sampling frequency, the measurement time at the sampling frequency and the associated inaccuracy are determined,
the charging voltage is measured with the determined sampling frequency and with the determined measurement time, and
the maximum of the charging voltage is determined.

**2.** Method according to Claim 1, in which the sampling frequency, the measurement time and the associated inaccuracy are determined by performing the following steps:

a) for each sampling frequency of a range of sampling frequencies, the following steps b) to e) are carried out,
b) for each phase difference value of a range of phase differences, the following steps c) to d) are carried out,
c) for each measurement time of a range of measurement times, the inaccuracy associated with a measurement at the frequency exhibiting a phase difference as function of the measurement time value is determined,
d) the lowest inaccuracy for each phase difference out of all the inaccuracies relative to the phase difference considered is chosen, for the sampling frequency considered,
e) the "worst case" inaccuracy is chosen for each sampling frequency out of the lowest inaccuracy values determined for each phase difference and for each sampling frequency considered,
f) the lowest inaccuracy is determined out of the lowest inaccuracy values determined for each sampling frequency,
g) the sampling frequency and the measurement time corresponding to the lowest inaccuracy are determined.

3. Method according to either one of the preceding claims, in which a range of sampling frequencies is defined, comprising a minimum frequency, a maximum frequency, and a frequency step, a range of phase differences is defined, comprising a minimum phase difference, a maximum phase difference and a phase difference step, and a range of measurement times is defined, comprising a minimum measurement time, a maximum measurement time and a measurement time step.

4. Method according to Claim 3, in which the maximum measurement time is defined as being derived from the product of the inverse of the sampling frequency by the integer part of the ratio of the frequency of the signal to be sampled to the sampling frequency.

**RÉFÉRENCES CITÉES DANS LA DESCRIPTION**

**Documents brevets cités dans la description**

- WO 2011058259 A